# EUROPEAN PATENT APPLICATION

(11) **EP 4 213 195 A1**
(43) Date of publication of application: **19.07.2023**
(21) Application number: 21864406.0
(22) Date of filing: 02.09.2021
(51) Int. Cl.: H01L 23/12, G09F 9/00, G09F 9/33, H05K 3/20, H05K 3/32

(54) **MOUNTED STRUCTURE, LED DISPLAY, AND MOUNTING METHOD**

(30) Priority: 07.09.2020 JP 2020150001
(71) Applicant: Daicel Corporation, Osaka 530-0011 (JP)
(72) Inventor: MIYAKE, Hiroto, Tokyo 108-8230 (JP); INADA, Yoshinobu, Tokyo 108-8230 (JP)
(74) Representative: Grünecker Patent- und Rechtsanwälte PartG mbB
(86) International application number: PCT/JP2021/032303
(87) International publication number: WO 2022/050353

(57) **Abstract**

There are provided a mounted structure that is excellent in precision with little joining deviation and can be efficiently produced, an LED display, and a mounting method. There are provided a mounted structure, an LED display including the mounted structure, and a manufacturing method for mounting a semiconductor element on a substrate. The mounted structure is a structure in which the semiconductor element including a terminal is mounted on the substrate including an electrode. The mounted structure includes a joining portion that joins the terminal and the electrode to make the terminal and the electrode oppose each other, the electrode is a bump of a bulk metal material disposed on the substrate, and the joining portion is obtained by thermally fusing metal nanoparticles in ink containing the metal nanoparticles transferred onto at least one of the electrode or the terminal by using a microcontact printing method.

## Description

### Technical Field

The present disclosure relates to a mounted structure in which a semiconductor element is mounted on a substrate, an LED display including the mounted structure, and a mounting method for mounting the semiconductor element on the substrate. The present application claims priority to JP 2020-150001 filed in Japan on September 7, 2020, the content of which is incorporated herein.

### Background Art

As a method for producing a printed circuit wiring board that is used in forming an electronic circuit by fixing electronic components on a surface of the printed circuit wiring board and connecting the electronic components with wiring lines, a method (subtractive method) is known in which a material with a metal layer formed on the entire surface of an insulating substrate by a wet process (non-electrolytic plating, electrolytic plating, or the like) or by a dry process (vacuum vapor deposition, sputtering, or the like) is used as a starting material, an unwanted portion of the metal layer of the starting material is etched utilizing a mask formed by using a photolithographic method, and metal wiring lines are formed by removing the mask after the completion of the etching. In recent years, the printed circuit wiring boards have been required to form finer wiring patterns to facilitate the densification of wiring boards accompanying the developments in miniaturization and functionality of electronic devices, but it is difficult for the subtractive method to precisely form a fine wiring pattern. The forming of a bump for connecting devices on the wiring lines and the joining the contact points with each other require significantly high precision, and therefore are carried out through complex processes.

In particular, in display devices such as displays equipped with precision components such as micro LEDs, as miniaturization is carried on, higher resolution is required. For example, in a micro LED display (µ-LED), about 24.9 million micro LEDs (three types of R, G, B (red, green, blue)) need to be precisely disposed on one substrate at 4K resolution. When the micro LEDs are disposed one by one on the substrate, the process needs a long-term. Because of this, it is required to efficiently form the wiring pattern. To meet this requirement, an ink-jet scheme is known as a method for forming a finer wiring pattern on a substrate at once (Patent Document 1). In the ink-jet scheme of Patent Document 1, a wiring pattern is formed on the substrate by discharging a metal nanoparticle paste through a nozzle onto the substrate and then heating. In addition, a contact printing scheme is also reported in which a paste containing conductive particles is applied on a surface of a resin template having been subjected to patterning including recesses and protrusions, and the surface of the resin template is pressed against a SiO₂/Si substrate, thereby forming a pattern of the conductive material on the substrate (Patent Document 2).

### Citation List

### Patent Document

Patent Document 1: JP 4539284 B
Patent Document 2: JP 2007-110054 A

### Summary of Invention

### Technical Problem

The ink-jet scheme of Patent Document 1 is a method of directly discharging a metal nanoparticle paste through a nozzle onto a substrate. At this time, the metal nanoparticle paste may scatter, blur, or spread on the substrate when observed at the nano-level. Due to this, there is a risk of a reduction in precision of the wiring pattern. In the contact printing scheme of Patent Document 2, a silver nano-paste is applied on a resin template to form a layer of the silver nano-paste having ups and downs according to the recesses and protrusions on the template. Thereafter, the template is pressed against the substrate to transfer only the silver nano-paste applied to the protruding portions onto the SiO₂/Si substrate. As a result, the silver nano-paste applied to the recessed portions of the template remains after the transfer, and therefore it is necessary to eliminate the remaining silver nano-paste by washing for successive use of the template. Accordingly, there is a risk that the same template cannot be used successively, thereby causing a reduction in production efficiency.

Thus, an object of the present disclosure is to provide: a mounted structure which is excellent in precision with little joining deviation and can be produced efficiently, and in which a semiconductor element is mounted on a substrate; an LED display including the mounted structure; and a mounting method for mounting the semiconductor element on the substrate.

### Solution to Problem

Through extensive study to accomplish the object described above, the inventors of the present disclosure have found that it is possible to achieve a mounted structure that is excellent in precision with little joining deviation and can be produced efficiently by thermally fusing metal nanoparticles in ink containing the metal nanoparticles transferred onto at least one of the terminal or an electrode that is a bump of a bulk metal material disposed on the substrate, by using a microcontact printing method. The present disclosure has been completed based on these findings.

That is, the present disclosure provides a mounted structure in which a semiconductor element including a terminal is mounted on a substrate including an electrode. The mounted structure includes a joining portion that joins the terminal and the electrode to make the terminal and the electrode oppose each other, the electrode is a bump of a bulk metal material disposed on the substrate, and the joining portion is obtained by thermally fusing metal nanoparticles in ink containing the metal nanoparticles transferred onto at least one of the electrode or the terminal by using a microcontact printing method.

In addition, the present disclosure provides a mounting method for mounting a semiconductor element including a terminal onto a substrate including an electrode. The electrode is a bump of a bulk metal material disposed on the substrate. Ink containing metal nanoparticles is transferred onto at least one of the electrode or the terminal by using a microcontact printing method, and thermal fusion is performed in a state in which the terminal and the electrode are in contact with each other, interposed with the ink containing the metal nanoparticles transferred onto at least one of the electrode or the terminal.

The average particle size of the metal nanoparticles is preferably in a range from 0.5 nm to 100 nm.

A mold used in the microcontact printing method described above preferably contains polysiloxane as a constituent material.

The mold used in the microcontact printing method preferably uses a polysiloxane mold including a film or a fibrous core material, a linear expansion coefficient of the mold being 200 ppm/K or less and a size of the mold being unchanged before and after being used repeatedly using a solvent.

The microcontact printing method is a letterpress printing scheme using a mold, and it is preferable that the ink containing the metal nanoparticles transferred onto at least one of the electrode or the terminal be ink obtained by transferring a portion of the ink that is adsorbed on a protrusion of the mold when the mold is pressed against the ink having been evenly applied on a flat plate.

The microcontact printing method is an intaglio printing scheme using a mold, and it is preferable that the ink containing the metal nanoparticles transferred onto at least one of the electrode or the terminal be ink obtained by transferring a portion of the ink that is filled in a recess of the mold when the mold is pressed against the ink having been evenly applied on a flat plate.

The microcontact printing method is an offset-technique printing scheme using a mold and an intermediate transfer body, and it is preferable that the ink containing the metal nanoparticles transferred onto at least one of the electrode or the terminal be ink obtained by transferring, onto at least one of the electrode on the substrate or the terminal, the ink that remains on the intermediate transfer body when the mold is pressed against the ink having been evenly applied on the intermediate transfer body and is separated from the intermediate transfer body.

The semiconductor element is preferably an LED element in which the length of the longest line among the lines connecting any two points on the outer periphery of the semiconductor element in a plan view is 100 µm or less.

The present disclosure provides an LED display including the mounted structure described above.

### Advantageous Effects of Invention

According to the mounted structure or the mounting method of the present disclosure, it is possible to achieve the mounted structure that is excellent in precision with little joining deviation and can be produced efficiently. In addition, the mounted structure of the present disclosure may be suitably used as an LED display.

### Brief Description of Drawings

FIG. 1(A) is a perspective view in which part of a mounted structure of the present disclosure is enlarged and illustrated, and FIG. 1(B) is a partial cross-sectional view of FIG. 1(A).
FIG. 2(A) is a plan view in which part of a mounted structure of the present disclosure is enlarged and illustrated, and FIG. 2(B) is a plan view in which part of a modified example of a mounted structure of the present disclosure is enlarged and illustrated.
FIG. 3(A) is a plan view of a master mold, FIG. 3(B) is a partially enlarged plan view of FIG. 3(A), and FIG. 3(C) is a partially enlarged plan view of FIG. 3(B).
FIGS. 4(A) to 4(E) are schematic diagrams illustrating an example of a method for forming a mold.
FIGS. 5(A) to 5(E) are schematic diagrams illustrating an example of transfer by a microcontact printing method.
FIGS. 6(A) to 6(E) are schematic diagrams illustrating another example of transfer by a microcontact printing method.
FIGS. 7(A) to 7(E) are schematic diagrams illustrating yet another example of transfer by a microcontact printing method.
FIGS. 8(A) to 8(E) are schematic diagrams illustrating a mounting method of the present disclosure.
FIG. 9 is a flowchart illustrating a mounting method of the present disclosure.

### Description of Embodiments

Hereinafter, embodiments for carrying out the present disclosure will be described. Note that each of the configurations, combinations thereof, and the like in each of the embodiments are an example, and various additions, omissions, substitutions, and other changes may be made as appropriate without departing from the spirit of the present disclosure. The present disclosure is not limited to the embodiments and is limited only to the claims.

### Mounted Structure

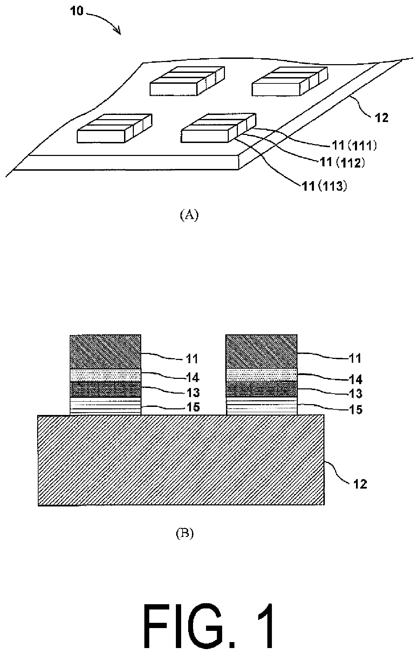

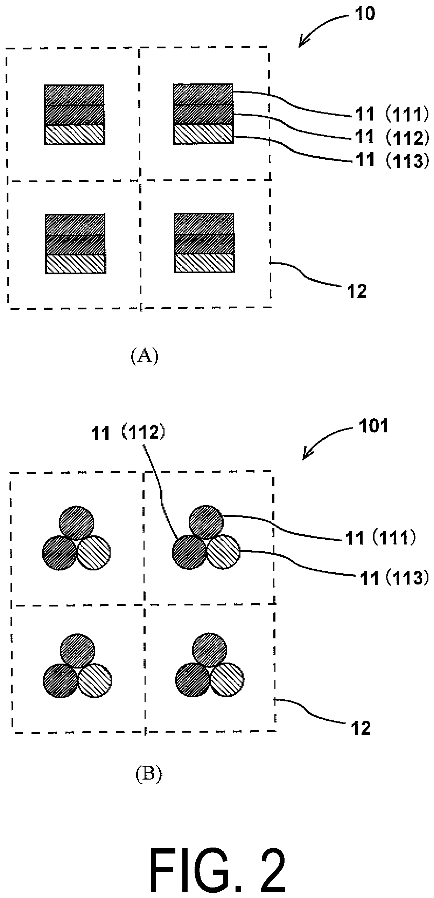

FIG. 1(A) is a perspective view in which part of a mounted structure (hereinafter, also referred to simply as a mounted structure) 10 of the present disclosure is enlarged and illustrated, and FIG. 1(B) is a partial cross-sectional view of FIG. 1(A). FIG. 2(A) is a plan view in which part of the mounted structure 10 is enlarged and illustrated, and FIG. 2(B) is a plan view in which part of a modified example of the mounted structure 10 is enlarged and illustrated. In FIG. 1(A), only a semiconductor element 11 and a substrate 12 are illustrated, and the other members are omitted. As illustrated in FIG. 1(A), FIG. 1(B), and FIG. 2(A), the mounted structure 10 includes a plurality of semiconductor elements 11, the substrate 12, and a plurality of joining portions 13. The semiconductor element 11 includes a terminal 14, and the substrate 12 includes an electrode 15. The semiconductor element 11 is mounted on the substrate 12 in such a manner that the terminal 14 and the electrode 15 oppose each other. The joining portion 13 joins the terminal 14 and the electrode 15. That is, the plurality of semiconductor elements 11 are each mounted on the substrate 12 with the joining portion 13 interposed therebetween.

The semiconductor element 11 is an electronic component using a semiconductor, and particularly indicates a microscale element herein. The semiconductor elements 11 include a semiconductor element 111, a semiconductor element 112, and a semiconductor element 113. For example, the semiconductor element 111 is a red micro LED, the semiconductor element 112 is a green micro LED, and the semiconductor element 113 is a blue micro LED. One pixel is constituted of one semiconductor element 111, one semiconductor element 112, and one semiconductor element 113. A plurality of the pixels each constituted of the semiconductor element 111, semiconductor element 112, and semiconductor element 113 are disposed being aligned at predetermined intervals on the substrate 12. In the present embodiment, three types of micro LEDs are given as examples of the semiconductor elements 11, but in accordance with the specifications, all the micro LEDs may be the same type, or a plurality of micro LEDs other than the above three types may be included. The size, the shape, the number of elements, and the like may be different depending on the luminance or the like of the individual semiconductor elements. For example, one pixel may be constituted by a combination of four semiconductor elements 11 including one semiconductor element 111, one semiconductor element 112, and two semiconductor elements 113.

The length of the longest line among the lines connecting any two points on the outer periphery of the semiconductor element 11 in a plan view is 100 µm or less. In the following, the plan view indicates a view when seen from a direction perpendicular to a planar direction of the substrate 12 or the like. To be specific, the semiconductor element 11 (111, 112, 113) is formed in a rectangular shape having a diagonal line of 100 µm or less in length in a plan view as illustrated in FIG. 2(A). When the semiconductor element 11 has a rectangular shape in a plan view, the length of the diagonal line is more preferably 70 µm or less, and further more preferably 35 µm or less.

FIG. 2(B) illustrates a mounted structure 101, which is a modified example of the mounted structure 10. In the description of the mounted structure 101, description similar to that of the mounted structure 10 is omitted, and only different portions are described. As illustrated in FIG. 2(B), the semiconductor element 11 (111, 112, 113) is formed in a circular shape having a diameter of 100 µm or less. When the semiconductor element 11 has a circular shape in a plan view, the diameter thereof is more preferably 50 µm or less, and further more preferably 20 µm or less. The shape of the semiconductor element 11 is not limited to a rectangular shape or a circular shape, and other shapes such as a polygonal shape, an elliptical shape and the like may be employed in accordance with the specifications.

The substrate 12 is a planar substrate including the electrode 15. Examples of the planar substrate include a glass plate; a semiconductor such as silicon, gallium arsenide, gallium nitride or the like; a composite substrate obtained by a base material such as glass cloth or nonwoven fabric being impregnated with resin such as an epoxy resin and being cured: a resin substrate of an epoxy resin cured product, an engineering plastic such as a liquid crystal polymer, polycarbonate, polypropylene, polyethylene or the like; a metal substrate; and a combination of these materials. The substrate 12 may include, in addition to the electrode 15, a pattern structure such as a fine wiring line, a crystalline structure, an optical waveguide, an optical structure such as holography or the like, as needed.

The substrate 12 is formed in a rectangular shape having a diagonal line of 600 mm or less in length in a plan view, for example. When the semiconductor element 11 has a rectangular shape in a plan view, the length of the diagonal line is more preferably 100 mm or less, and further more preferably 75 mm or less. The shape of the substrate 12 is not limited to a rectangular shape, and other shapes such as a polygonal shape, a circular shape, an elliptical shape and the like may be employed in accordance with the specifications.

The electrode 15 is a bump (protrusion) of a bulk metal material disposed on the substrate 12. It is preferable that the bulk metal material be electrically conductive and have low resistance. Examples of components constituting the bulk metal material include metal, metal salts such as metal oxide, carbon and the like. The components constituting the bulk metal material may be composed of only one type of component, or may include a plurality of types of components. Among the above-mentioned components, metal is preferred as the component constituting the bulk metal material. The metal may be, for example, a single element such as gold, silver, palladium, platinum, nickel, copper, iron, lead, cobalt, manganese, aluminum, zinc, bismuth, silicon, tin, cadmium or indium, a plurality of elements of these metals, or metal oxides or salts of these metals.

The electrode 15 is disposed on the substrate 12 in accordance with the specifications of the mounted structure 10. The electrode 15 is disposed at a position corresponding to each of the semiconductor elements 11.

The joining portion 13 includes a material having electrical conductivity. Examples of the material having electrical conductivity include metal, metal salts such as metal oxide, carbon and the like, and a mixture of these materials. Examples of the metal include gold, silver, palladium, platinum, nickel, copper, iron, lead, cobalt, manganese, aluminum, zinc, bismuth, silicon, tin, cadmium, indium and the like. Silver is particularly preferred among the metals. Silver nanoparticles are versatile and have a low melting point, and therefore can be sintered at relatively low temperatures. This makes it possible to maintain temperatures of thermal fusion and the like at relatively low temperatures, and suppress the effect of heat on the semiconductor element 11 and the substrate 12.

The joining portion 13 is formed, for example, by thermally fusing the metal nanoparticles made of the metal described above. Regarding the heating conditions of the thermal fusion, the temperature is preferably in a range from 100°C to 200°C, more preferably in a range from 100°C to 150°C, and further more preferably in a range from 100°C to 120°C. When the temperature is 100°C or higher, the metal nanoparticles may be sufficiently fused and integrated. The heating time is preferably 120 minutes or less, more preferably 15 minutes or less, and further more preferably 5 minutes or less. This makes it possible to sufficiently join the terminal 14 and the electrode 15. The joining portion 13 may be mixed and integrated with part of the terminal 14 and the electrode 15, which are fused by the thermal fusion. With this, the terminal 14 may be more firmly joined to the electrode 15.

The metal nanoparticles are those obtained by transferring ink containing metal nanoparticles onto the electrode 15 by using the microcontact printing method. The ink containing the metal nanoparticles may be transferred onto the terminal 14 on the semiconductor element 11 side instead of being transferred onto the electrode 15 on the substrate 12 side. The ink containing the metal nanoparticles may be transferred onto both the electrodes 15 and the terminal 14. In other words, the ink containing the metal nanoparticles may be transferred onto at least one of the electrode 15 or the terminal 14.

The microcontact printing method may transfer the ink containing the metal nanoparticles to a plurality of locations at a time by using a mold described below. The ink containing the metal nanoparticles is the one in which the metal nanoparticles are dispersed in a solvent. Examples of the solvent include aliphatic hydrocarbon solvents such as pentane, hexane, heptane, octane, nonane, decane, undecane, dodecane, tridecane, tetradecane and the like; alicyclic hydrocarbon solvents such as cyclohexane, methylcyclohexane, decalin and the like; aromatic hydrocarbon solvents such as toluene, xylene, mesitylene and the like; straight-chain or branched aliphatic alcohol solvents such as methanol, ethanol, n-propanol, isopropanol, n-butanol, isobutanol, sec-butanol, tert-butanol, n-pentanol, n-hexanol, 2-ethylhexanol, n-heptanol, n-octanol, n-nonanol, n-decanol, undecanol, dodecanol and the like; circular (or circular structure-containing) aliphatic alcohol solvents such as cyclopentanol, cyclo hexanol, cyclohexamethanol and the like; polyols such as ethylene glycol, propylene glycol, diethylene glycol or the like, and ether and ester thereof; and terpene-based solvents such as terpineol, dihydro-terpineol and the like. When the metal nanoparticles are used for forming the joining portion 13, the usage amount may be reduced compared to the case of using the bulk metal, and the metal may be disposed in a fine region by using the microcontact printing method. The transfer by the microcontact printing method will be described in detail later.

The average particle size (median size, D50) of the metal nanoparticles is not particularly limited, but is preferably in a range from 0.5 nm to 100 nm, more preferably in a range from 0.5 nm to 35 nm, and further more preferably in a range from 0.5 nm to 25 nm. When the average particle size of the metal nanoparticles is 0.5 nm or greater, handling thereof during the preparation of ink is easy compared to a case of the average particle size being less than 0.5 nm. When the average particle size of the metal nanoparticles is 100 nm or less, the metal particles are evenly dispersed with respect to the solvent, thereby making it possible to form a coating film of evenly formed ink in which nonuniformity in distribution of the metal nanoparticles is suppressed. When the average particle size of the metal nanoparticles is in a range from 0.5 nm to 100 nm, the amount in quantity of the metal nanoparticles used for obtaining sufficient electrical conductivity may be suppressed and caused to be smaller than or equal to a predetermined amount. The average particle size of the metal nanoparticles is a value determined by the number average; for example, particle sizes of 100 metal nanoparticles optionally selected from an image captured using a transmission electron microscope are measured, and then the average particle size of the metal nanoparticles can be determined from the average value of the measured particle sizes.

The joining portion 13 formed by thermally fusing the metal nanoparticles in the ink joins the terminal 14 and the electrode 15. Thus, the semiconductor element 11 is mounted on the substrate 12. Since the plurality of joining portions 13 are formed at a time using the microcontact printing method, the semiconductor elements 11 may be efficiently and precisely mounted on the substrate 12.

The mounted structure 10 of the present disclosure may be preferably used, for example, as an optical component such as an LED (including an LED display), a display element for head-up display, a backlight of a liquid crystal display or the like, lighting, a visible light communication device or the like. The semiconductor elements 11 can be efficiently and precisely mounted on the substrate 12, and therefore the mounted structure 10 may be preferably used as a micro LED, which is a specially miniaturized device, or the like. Examples of the micro LED include a device in which the length of the longest line among the lines connecting any two points on the outer periphery of the LED element in a plan view (for example, the length of the diameter in a case of a circular shape) is 100 µm or less. A mold used in the microcontact printing method and a master mold for forming the mold are described below.

### Master Mold

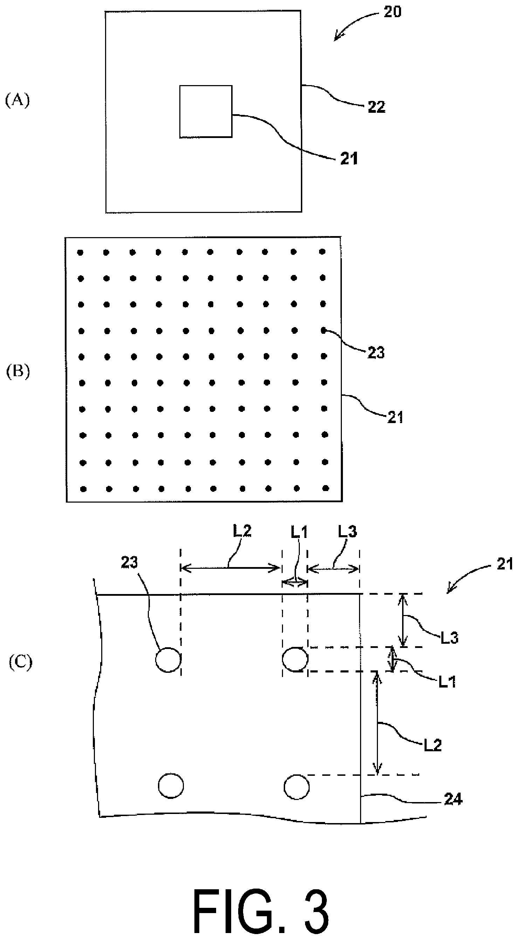

FIG. 3(A) is a plan view of a master mold 20, FIG. 3(B) is a plan view in which a transfer portion 21, which is part of FIG. 3(A), is enlarged and illustrated, and FIG. 3(C) is a plan view in which part of the transfer portion 21 of FIG. 3(B) is further enlarged and illustrated. The master mold 20 is a mold for forming the mold to be used in the microcontact printing method. A pattern shape of an inverted recess-protrusion shape for imparting a desired shape to the mold is imparted to the master mold 20; the pattern shape of the inverted recess-protrusion shape (an inverted shape of the desired mold) corresponds to the desired shape of the mold. The master mold 20 is a structure in which fine shapes of recesses and protrusions are formed on a surface of Si, quartz, metal or the like, and this structure is very expensive and is also referred to as a master. A mold is formed based on the expensive master mold and the pattern formation is carried out by the microcontact printing method using the above-formed mold, and thus the costs may be reduced significantly.

As illustrated in FIG. 3(A), the master mold 20 includes the transfer portion 21 and a peripheral portion 22. The outer shape of each of the transfer portion 21 and the peripheral portion 22 is rectangular in a plan view, and the peripheral portion 22 surrounds the transfer portion 21. The length of one side of the master mold 20 (the length of one side of the perimeter of the peripheral portion 22) is preferably in a range from 10 mm to 700 mm, more preferably in a range from 10 mm to 150 mm, and further more preferably in a range from 10 mm to 100 mm. The length of one side of the transfer portion 21 is preferably in a range from 10 mm to 600 mm, more preferably in a range from 10 mm to 100 mm, and further more preferably in a range from 10 mm to 50 mm. The shape of each of the transfer portion 21 and the peripheral portion 22 is not limited to a rectangular shape, and other shapes such as a polygonal shape, a circular shape, an elliptical shape and the like may be employed in accordance with the specifications.

As illustrated in FIGS. 3(B) and 3(C), the transfer portion 21 has a recess-protrusion shape on the surface thereof. The transfer portion 21 includes a plurality of recesses 23 formed being separated from each other by a predetermined interval, for example. The recess 23 has a shape recessed in a columnar shape from the surface of the transfer portion 21 to the interior thereof, for example. The shape of the recess 23 is not limited to a columnar shape, and a polygonal prism shape or the like may be employed in accordance with the specifications. The side of the recess 23 recessed to the interior may be formed in a planar shape, or may be formed in a three-dimensional shape, for example, in a hemispherical shape.

When the recess 23 is formed in a columnar shape, a diameter (L1) of the recess 23 in a plan view is preferably 100 µm or less, more preferably 50 µm or less, and further more preferably 10 µm or less. The depth of the recess 23 is preferably 200 µm or less, more preferably 100 µm or less, and further more preferably 20 µm or less.

An interval (L2) between the recesses 23 of the transfer portion 21 is designed in accordance with the layout of each color of the semiconductor elements 11 (111, 112, 113). The interval between the recesses 23 of the transfer portion 21 may be changed as appropriate in accordance with the specifications of the mounted structure 10. For example, when the master mold 20 and the substrate 12 are overlapped each other, the recesses 23 are formed at positions overlapping all of the electrodes 15 on the substrate 12 or at positions overlapping at least some of the electrodes 15. In the case where ink is transferred onto the terminal 14 on the semiconductor element 11 side, when the master mold 20 and the semiconductor elements 11 are overlapped each other, the recesses 23 are formed at positions overlapping all of the terminals 14 on the semiconductor elements 11 or at positions overlapping at least some of the terminals 14. Since the plurality of semiconductor elements 11 are present, it is preferable to treat them in such a manner that the plurality of semiconductor elements 11 are loaded on a chip board, for example.

A shortest distance (L3) of the recess 23 from an edge 24 of the transfer portion 21 is preferably 100 µm or less, preferably 30 µm or less, and more preferably 10 µm or less.

### Mold

The mold of the present disclosure (hereinafter, also referred to simply as the mold) is made of a cured product or a solidified product of a resin composition (hereinafter, also referred to as a mold-forming resin composition) that forms a mold. The mold is, for example, a film made of a cured product or a solidified product of a resin composition that forms a mold. The mold may be a structure in which a cured product or a solidified product of the mold-forming resin composition is laminated on a base member. A mold containing a fibrous core material may be cited as an example. The base member includes the fibrous core material, and supports a cured product or a solidified product of the mold-forming resin composition.

The cured product or the solidified product of the mold-forming resin composition has a recess-protrusion shape on the surface thereof. The master mold 20 imparts, to the mold, a pattern shape of an inverted recess-protrusion shape corresponding to the shape of the master mold 20. At a location in the mold corresponding to the transfer portion 21 of the master mold 20, a plurality of the protrusions are formed at the locations corresponding to the plurality of recesses 23. The mold-forming resin composition includes resin and a curable composition for forming a mold.

It is preferable that the mold use a mold including a film or a fibrous core material, a linear expansion coefficient of the mold being 200 ppm/K or less and a size of the mold being unchanged before and after being used repeatedly using a solvent. The linear expansion coefficient of the mold is more preferably 100 ppm/K or less, and further more preferably 50 ppm/K or less. When the linear expansion coefficient of the mold is 200 ppm/K or less, a change in volume due to heat of the mold is small. As a result, deformation of the mold due to heat or the like generated by friction is suppressed, and more precise transfer may be carried out when used in the microcontact printing method. When the size of the mold does not change before and after the mold being used repeatedly using a solvent, a change in volume of the mold caused by the solvent is small. Therefore, the deformation of the mold due to the solvent contained in the ink is suppressed, and thus more precise transfer may be carried out when the mold is used in the microcontact printing method. The value of the change in size before and after the mold being used repeatedly using a solvent is obtained by comparing the dimensions of the initial mold with the dimensions of the mold after being used repeatedly using the solvent. As the dimensions of the mold after being used repeatedly using the solvent, for example, the dimensions of a mold that is impregnated with the solvent for one hour at room temperature and then is subjected to drying under reduced pressure (10 Pa, 80°C, two hours) may be tentatively used.

Examples of the mold including the fibrous core material include a mold in which there is laminated a mold part where a pattern shape of a recess-protrusion shape is imparted onto the fibrous core material hardened with a resin similar to the mold. Examples of the fibrous core material include fabric including a material having low elasticity. Specific examples thereof include nonwoven fabric made of cellulose, cotton or the like, and woven fabric such as glass cloth. By using a mold including a fibrous core material, the mold is strengthened by the fibrous core material, and stable transfer properties may be obtained without being affected by a tensile force at the time of transfer. Furthermore, since the fibrous core material suppresses the volume change due to heat and the swelling due to the solvent, the deformation of the mold itself may be suppressed.

Examples of the resin for forming the above-discussed mold include polysiloxane (dimethylpolysiloxane or the like) as a silicone-based resin, a fluorine-based resin, polyolefin-based resin (polyethylene, polypropylene, polycyclic olefin, or the like), polyethersulfone-based resin, polycarbonate-based resin, polyester-based resin (polyarylate, polyethylene terephthalate, polyethylene naphthalate, or the like), polyamide-based resin, polymethyl methacrylate and the like.

Among the above resins, polysiloxane is particularly preferred. In the curing of the mold-forming resin composition, for example, a three-dimensional crosslinking reaction by hydrosilylation to an unsaturated double bond, a radical polymerization, an epoxy reaction, or the like may be used. Examples of the curable composition include polysiloxane containing an epoxy compound and the like. When polysiloxane is used as the resin, the compatibility with a curable composition such as an epoxy compound is excellent, and the contact angle is likely to be small. In addition, when polysiloxane is used as the above-discussed resin and curable composition, the obtained mold is excellent in flexibility, and thus a protruding portion of the mold may extend flexibly along other contacting objects such as a flat plate and may be in contact with the contacting objects when used in the microcontact printing method. As a result, the ink applied to the flat plate and the like may be adsorbed on the protruding portion of the mold without nonuniformity. Since the mold is excellent in releasability and flexibility, the mold may be more easily taken out from the master mold 20.

In addition to the above-described components, other components such as a release agent may be added to the mold-forming resin composition as needed. For example, an organic solvent may be added to adjust the viscosity. Examples of the organic solvent include a saturated or unsaturated hydrocarbon solvent such as pentane, hexane, heptane, octane, petroleum ether or the like; an aromatic hydrocarbon-based solvent such as benzene, toluene, xylene or the like; ketone such as acetone, methyl ethyl ketone, methyl isobutyl ketone, methyl n-amyl ketone, cyclohexanone or the like; alcohol such as methanol, ethanol, n-butanol or the like; and ether such as 1,2-dimethoxyethane, tetrahydrofuran, dioxane or the like. One of these can be used alone or two or more in combination. It is preferable that the viscosity of the mold-forming resin composition (at 25°C) be adjusted to be approximately in a range from 1 to 100 mPa·s, for example, from the perspective of application properties. The viscosity of the mold-forming resin composition may be measured using a digital viscometer (model No. "DVU-EII", available from TOKIMEC INC.) under the conditions of rotor: standard 1°34' x R24, temperature: 25°C, and rotation speed: from 0.5 to 10 rpm. An example of a method for forming a mold is described below.

### Method for Forming Mold

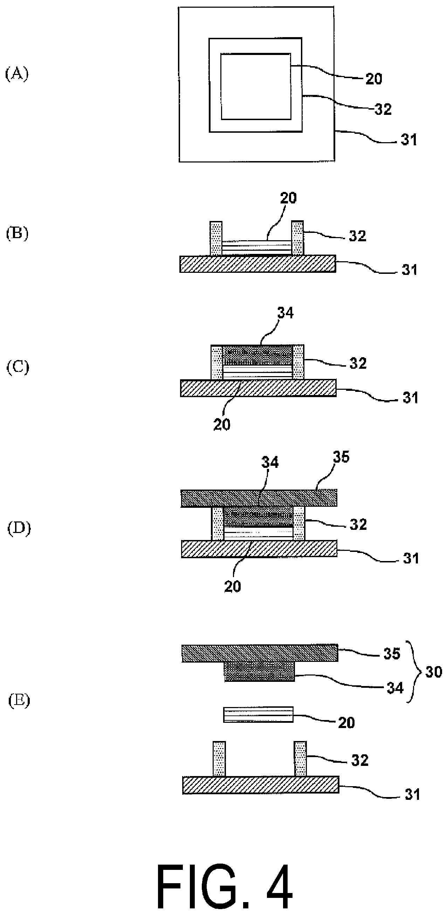

FIGS. 4(A) to 4(E) are schematic diagrams illustrating an example of a method for forming a mold. FIG. 4(A) is a schematic plan view, and FIG. 4(B) is a schematic cross-sectional view of FIG. 4(A). First, as illustrated in FIG. 4(A) and FIG. 4(B), a mold set in which the master mold 20 is set is prepared. Specifically, the master mold 20 and a frame 32 are disposed on a plate 31. In this case, the master mold 20, the plate 31, and the frame 32 each have a square shape in a plan view, but the square shape is an example and the shape thereof is not limited to the square shape.

The frame 32 is formed in a shape surrounding the master mold 20 in a plan view. The length of each side on the inner side of the frame 32 is the same as the length of each side of the master mold 20. In other words, in a case where the master mold 20 is a square with a side of 20 mm in a plan view, the length of each side on the inner side of the frame 32 is 20 mm. With this, the periphery in a horizontal direction of the master mold 20 is fitted into the frame 32. It is preferable for the thickness in the horizontal direction of the frame 32 in a plan view to be 0.5 mm or greater, preferable to be 1 mm or greater, and more preferable to be 10 mm or greater. The thickness in a vertical direction of the frame 32 is preferably a length obtained by adding a desired mold thickness to the thickness in a vertical direction of the master mold 20. As a result, by filling the inner side of the frame 32 with a mold-forming resin composition 34 up to the edge on the upper side thereof, the mold having the desired thickness is obtained. The plate 31 is preferably formed in a flat plate shape, and is provided with a plane direction being level. This makes it possible to obtain the mold in which unwanted nonuniformity in thickness in the horizontal direction is suppressed.

The material of the plate 31 is preferably excellent in heat resistance, and examples thereof include an inorganic material such as glass, silicon or the like; a resin such as a cycloolefin-based polymer, polycarbonate, polypropylene, polyethylene, epoxy or the like; metal; and a combination of these material or the like. When the plate 31 has superior heat resistance, deformation thereof is suppressed when the mold is cured by heat, and the mold in which the recesses and protrusions are precisely transferred from the master mold 20 is obtained. The material of the frame 32 preferably has heat resistance and chemical resistance, and examples thereof include fluorine resins such as Teflon (trademark), cycloolefin-based polymers and the like. When the frame 32 has heat resistance, deformation of the frame 32 is suppressed when the mold is cured by heat. When the frame 32 has chemical resistance, deformation of the frame 32 caused by the resin forming the mold is suppressed. Thus, the mold on which the recesses and protrusions of the master mold 20 are precisely transferred is obtained. The surface of the frame 32 may be subjected to mold release processing with a fluorine-based silane coupling agent or the like as necessary.

Subsequently, as illustrated in FIG. 4(C), the mold-forming resin composition 34 described above is fed into a space surrounded by the frame 32 on the master mold 20 of the mold set. The mold-forming resin composition 34 is filled in the space surrounded by the master mold 20 and the frame 32.

Further, the mold-forming resin composition 34 having been filled is preferably defoamed by a defoaming process. The defoaming may be carried out by a known or commonly used defoaming method. In particular, defoaming by decompression (decompression degassing, vacuum degassing) is preferred. The decompression gassing may be carried out, for example, by statically setting the mold set filled with the mold-forming resin composition 34 under a pressure of 0.1 kPa to 20 kPa for 1 to 10 minutes. As a result, bubbles within the mold-forming resin composition 34 are discharged to the outside. Thus, the bubbles adsorbed on the recesses and protrusions of the master mold 20, for example, may be eliminated, and the mold on which the recesses and protrusions of the master mold 20 are precisely transferred may be obtained.

Subsequently, as necessary, a base member 35 is overlaid to be in close contact to the mold-forming resin composition 34 having been filled, as illustrated in FIG. 4(D). The mold-forming resin composition 34 is sandwiched between the master mold 20 and the base member 35, and the base member 35 may be a mold including the fibrous core material described above. The mold-forming resin composition 34 is likely to be integrated with the base member 35 including the fibrous core material when being cured. After the base member 35 is overlaid on the mold-forming resin composition 34, the laminated members, that is, the plate 31, the master mold 20, the mold forming resin composition 34, and the base member 35 may be pressed in a lamination direction. Consequently, the adhesion of each member is increased, and a variation in thickness in the lamination direction may be prevented. The pressure during pressing is, for example, from 0.01 to 100 MPa.

Subsequently, the mold-forming resin composition 34 laminated with the plate 31, the master mold 20, and the base member 35 is cured through a curing process. In the curing process, the mold-forming resin composition 34 may be cured by conducting a polymerization reaction of a curable compound (particularly, a cation-curable compound) contained in the mold-forming resin composition 34. The curing method may be appropriately selected from known or commonly used methods. The curing method is not particularly limited, and examples thereof include a method of heating and/or a method of irradiation with active energy rays.

Heating is preferred as the curing method. In the case of heating, it is unnecessary to transmit light for irradiation to the mold-forming resin composition 34, and thus other members surrounding the mold-forming resin composition 34 are not required to have light-transmissive properties. As for the heating conditions, the temperature of heating is preferably 80°C or higher, more preferably 100°C or higher, and further more preferably 150°C or higher. When the temperature is 80°C or higher, the mold-forming resin composition 34 is sufficiently cured. The curing time is preferably 15 minutes or longer, more preferably 30 minutes or longer, and further more preferably 90 minutes or longer. When the curing time is 15 minutes or longer, the mold-forming resin composition 34 is sufficiently cured. The mold-forming resin composition 34 is integrated with the base member 35 when being cured. As a result, the mold 30, in which the mold-forming resin composition 34 and the base member 35 are integrated, is formed.

In a case where curing is carried out by the method of irradiation with active energy rays, any of infrared rays, visible rays, ultraviolet rays, X-rays, electron beams, α-rays, β-rays, γ-rays and the like, for example, may be used as the active energy rays. Among these, ultraviolet rays are preferred in terms of excellent handling. A highpressure mercury lamp, ultra-high pressure mercury lamp, carbon arc lamp, xenon lamp, metal halide lamp or the like is used as the light source when irradiation with ultraviolet light is performed. The irradiation time depends on the type of the light source, the distance between the light source and the coated surface, and other conditions, but is several tens of seconds at the longest. The illuminance is, for example, approximately 5 to 200 mW/cm². After the irradiation with the active energy ray, heating (post curing) may be performed as necessary to promote the curing.

After the curing process, the mold 30 having been formed may be taken out by being removed from the plate 31, the frame 32, and the master mold 20, as illustrated in FIG. 4(E). Thus, the mold 30 is obtained.

When the mold is a film formed of a cured product of the mold-forming resin composition 34, a member similar to the plate 31 is used in place of the base member 35 in the above-discussed mold forming method. After the mold-forming resin composition 34 is cured, the cured mold-forming resin composition 34 may be taken out by being removed from the plate 31, the frame 32, the master mold 20, and the member similar to the plate 31. With this, the mold that is a film formed of a cured product of the mold-forming resin composition 34 is obtained.

### Transfer Method 1 by Microcontact Printing Method

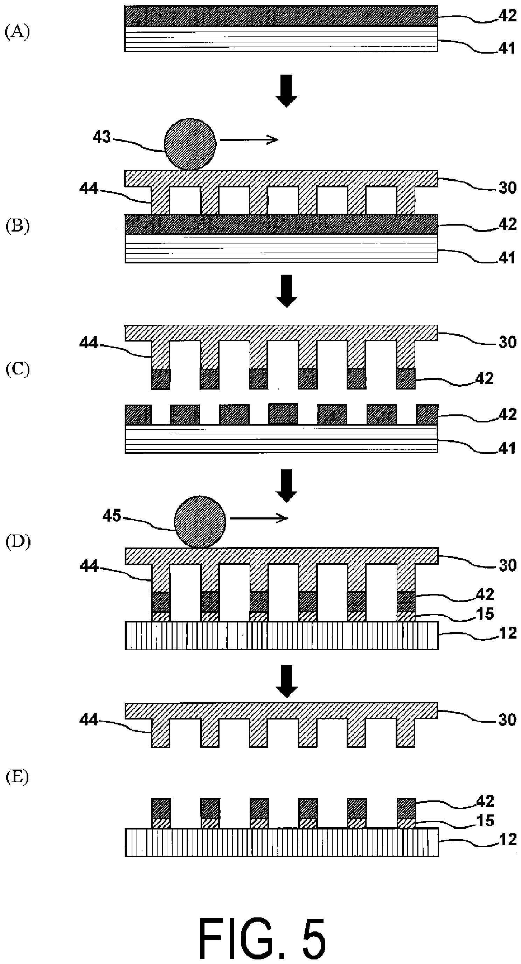

FIGS. 5(A) to 5(E) are schematic diagrams illustrating an example of a transfer method by a microcontact printing method (hereinafter, also referred to as transfer method 1). Transfer Method 1 is a letterpress printing scheme using a mold. The description thereof will be given below with reference to FIGS. 5(A) to 5(E).

First, as illustrated in FIG. 5(A), ink 42 containing the above-described metal nanoparticles (hereinafter, also referred to as ink 42) is evenly applied on a smooth surface of a flat plate 41. In the flat plate 41, at least the surface on which the ink 42 is applied is smooth, in other words, the flat plate 41 is a plate product that does not have a recess-protrusion shape like the shape of letterpress and intaglio, and preferably is unlikely to deform with high rigidity. The flat plate 41 may be set on either a flat surface or a curved surface, for example, may be set on a drum surface. Examples of a material of the flat plate 41 include glass; silicon; resin such as polycarbonate, polypropylene, polyethylene or the like; a metal; and a combination of these materials or the like.

As an application method of the ink 42, a spray method, a spin coating method, a screen printing method, or the like may be used. The thickness of a coating film of the ink 42 is, for example, preferably in a range from 1 µm to 100 µm, more preferably in a range from 1 µm to 50 µm, further more preferably in a range from 1 µm to 20 µm, and most preferably in a range form from 1 µm to 10 µm. In the case where the coating film thickness of the ink 42 is in the range form 1 µm to 10 µm, the ink 42 contains a suitable amount of metal nanoparticles, thereby making it possible to sufficiently join the semiconductor element 11 to the substrate 12 at the time of thermal fusion.

Subsequently, as illustrated in FIG. 5(B), the mold 30 is pressed against the ink 42 having been applied. The mold 30 is pressed in such a manner that the side at which a protrusion 44 is present faces the flat plate 41. A pressure is applied as needed from a side opposite to the side where the mold 30 is pressed against the ink 42 by a roller 43. It is preferable for the pressure to be 1000 Pa or larger, more preferable to be 10000 Pa or larger, and further more preferable to be 100000 Pa or larger. With this, the mold 30 is evenly pressed against the flat plate 41 side without nonuniformity by the roller 43. Accordingly, the ink 42 can evenly adhere to the protrusion 44 of the mold 30.

As illustrated in FIG. 5(C), the mold 30 is separated from the flat plate 41. At this time, the ink 42 is separated from the flat plate 41 while being adsorbed on the protrusion 44 of the mold 30.

As illustrated in FIG. 5(D), the mold 30 is pressed against the substrate 12 having the electrode 15. It is preferable that the electrode 15 be disposed at a location facing the protrusion 44 when the substrate 12 faces the mold 30. The electrodes 15 may be disposed at the locations facing all of the protrusions 44, or at the locations facing some of the protrusions 44 as needed.

A side at which the protrusion 44 of the mold 30 is provided and a side at which the electrode 15 of the substrate 12 is provided face each other and are pressed against each other. Thus, the ink 42 adsorbed on the protrusion 44 is pressed against the electrode 15 of the substrate 12. A pressure is applied as needed from a side opposite to the side where the mold 30 is pressed against the ink 42 by a roller 45. It is preferable for the pressure to be 1000 Pa or larger, more preferable to be 10000 Pa or larger, and further more preferable to be 100000 Pa or larger. With this, the mold 30 is evenly pressed against the substrate 12 side without nonuniformity by the roller 45. Accordingly, the ink 42 can evenly adhere onto the electrode 15 of the substrate 12.

As illustrated in FIG. 5(E), the mold 30 is separated from the substrate 12. At this time, the ink 42 is separated from the mold 30 while being adsorbed on the electrode 15 of the substrate 12. Thus, the microcontact printing method using the mold 30 may precisely transfer the ink 42 to a plurality of locations on the electrodes 15 at a time.

### Transfer Method 2 by Microcontact Printing Method

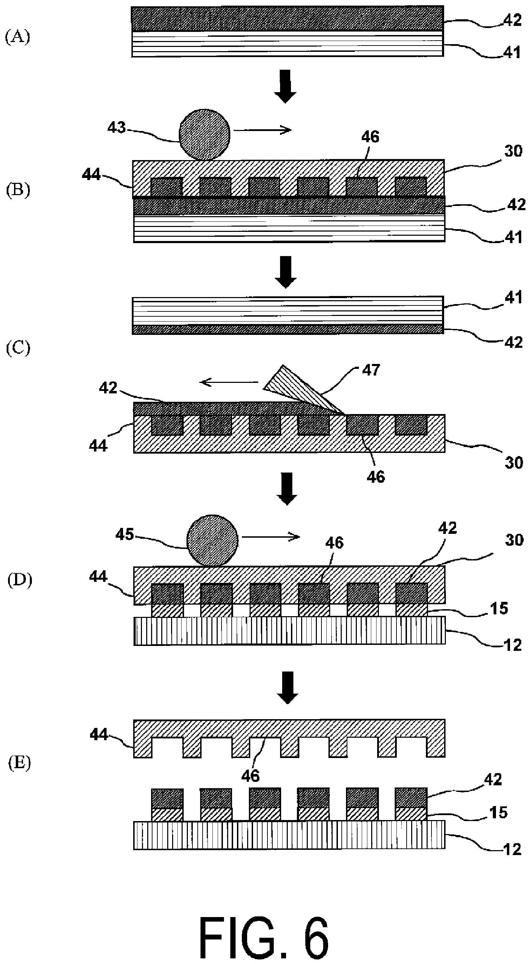

FIGS. 6(A) to 6(E) are schematic diagrams illustrating another example of transfer by the microcontact printing method (hereinafter, also referred to as transfer method 2). Transfer Method 2 is an intaglio printing scheme using a mold. The description thereof will be given below with reference to FIGS. 6(A) to 6(E). Note that the same contents as those of transfer method 1 described above are omitted.

First, as illustrated in FIG. 6(A), ink 42 containing the above-described metal nanoparticles (hereinafter, also referred to as ink 42) is evenly applied on a flat plate 41. The thickness of a coating film of the ink 42 is, for example, preferably in a range from 1 µm to 150 µm, more preferably in a range from 2 µm to 100 µm, and further more preferably in a range from 5 µm to 50 µm.

Subsequently, as illustrated in FIG. 6(B), a mold 30 is pressed against the ink 42 having been applied. The mold 30 includes a protrusion 44 and a recess 46.

A pressure is applied as needed from a side opposite to the side where the mold 30 is pressed against the ink 42 by a roller 43. It is preferable for the pressure to be 1000 Pa or larger, more preferable to be 10000 Pa or larger, and further more preferable to be 100000 Pa or larger. With this, the mold 30 is evenly pressed against the flat plate 41 side without nonuniformity by the roller 43. Accordingly, the ink 42 evenly enters into the recess 46 of the mold 30.

As illustrated in FIG. 6(C), the mold 30 is separated from the flat plate 41. At this time, the ink 42 is separated from the flat plate 41 while being filled in the recess 46 of the mold 30. An excess of ink 42 in the mold 30 is removed as needed. The removal of the ink 42 may be carried out by a known or commonly used method. The removal of the ink 42 may be carried out by, for example, scraping away the excess of ink 42 on the surface of the mold 30 with a spatula 47 or the like. This makes it possible to remove the excess of ink 42 attached to the protrusions 44 of the mold 30.

As illustrated in FIG. 6(D), the mold 30 is pressed against the substrate 12 having the electrode 15. It is preferable that the electrode 15 be disposed at a location facing the recess 46 when the substrate 12 faces the mold 30. The electrodes 15 may be disposed at the locations facing all of the recesses 46, or at the locations facing some of the recesses 46 as needed.

A side at which the recess 46 of the mold 30 is provided and a side at which the electrode 15 of the substrate 12 is provided face each other and are pressed against each other. Thus, the ink 42 being filled in the recess 46 is pressed against the electrode 15 of the substrate 12. A pressure may be applied as needed from a side opposite to the side where the mold 30 is pressed against the ink 42 by the roller 45. With this, the mold 30 is evenly pressed against the substrate 12 side without nonuniformity by the roller 45. Accordingly, the ink 42 can evenly adhere onto the electrode 15 of the substrate 12.

As illustrated in FIG. 6(E), the mold 30 is separated from the substrate 12. At this time, the ink 42 is separated from the mold 30 while being adsorbed on the electrode 15 of the substrate 12. Thus, the microcontact printing method using the mold 30 may precisely transfer the ink 42 to a plurality of locations on the electrodes 15 at a time.

The ink 42 may be transferred onto the terminal 14 on the semiconductor element 11 side instead of being transferred onto the electrode 15 on the substrate 12 side. The ink 42 may be transferred onto both the electrodes 15 and the terminal 14. In the following description of the method for mounting the semiconductor element on the substrate, a case in which the ink 42 is transferred onto the terminal 14 on the semiconductor element 11 side will be explained.

### Transfer Method 3 by Microcontact Printing Method

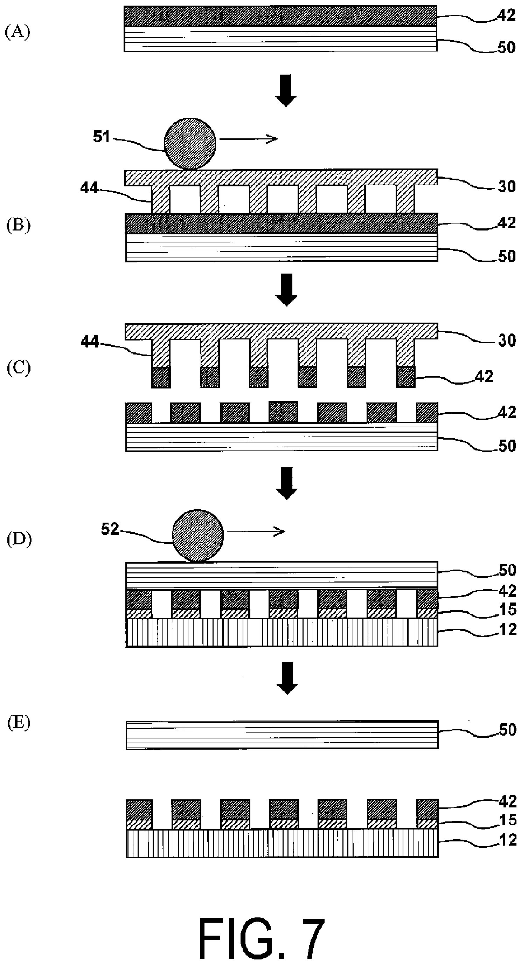

FIGS. 7(A) to 7(E) are schematic diagrams illustrating still another example of transfer by the microcontact printing method (hereinafter, also referred to as transfer method 3). Transfer Method 3 is a printing scheme using an intermediate transfer body, that is, a printing scheme of an offset technique (in particular, an inverted offset technique). The description thereof will be given below with reference to FIGS. 7(A) to 7(E). Note that the same contents as those of transfer method 1 described above are omitted.

First, as illustrated in FIG. 7(A), ink 42 containing the above-described metal nanoparticles is evenly applied onto an intermediate transfer body 50. The thickness of a coating film of the ink 42 is, for example, preferably in a range from 1 µm to 100 µm, more preferably in a range from 1 µm to 50 µm, further more preferably in a range from 1 µm to 20 µm, and most preferably in a range form from 1 µm to 10 µm. In the case where the coating film thickness of the ink 42 is in the range form 1 µm to 10 µm, the ink 42 contains a suitable amount of metal nanoparticles, thereby making it possible to sufficiently join the semiconductor element 11 to the substrate 12 at the time of thermal fusion.

As the intermediate transfer body 50, the same member as the above-described mold may be used except that a side thereof on which the ink 42 is applied is a flat plane without including recesses and protrusions. That is, it is preferable that the intermediate transfer body use an intermediate transfer body including a film or a fibrous core material, a linear expansion coefficient of the intermediate transfer body being 200 ppm/K or less and a size thereof being unchanged before and after being used repeatedly using a solvent. The linear expansion coefficient of the intermediate transfer body is more preferably 100 ppm/K or less, and further more preferably 50 ppm/K or less. When the linear expansion coefficient of the intermediate transfer body is 200 ppm/K or less, a change in volume due to heat of the intermediate transfer body is small. As a result, deformation of the intermediate transfer body due to heat or the like generated by friction is suppressed, and more precise transfer may be carried out when used in the offset scheme. When the size of the intermediate transfer body does not change before and after the intermediate transfer body being used repeatedly using a solvent, a change in volume of the intermediate body caused by the solvent is small. Therefore, the deformation of the intermediate transfer body caused by the solvent contained in the ink is suppressed, and more precise transfer may be carried out when used in the offset scheme. The value of the change in size before and after the intermediate transfer body being used repeatedly using a solvent is obtained by comparing the dimensions of the initial intermediate transfer body with the dimensions of the intermediate transfer body after being used repeatedly using the solvent. As the dimensions of the intermediate transfer body after being used repeatedly using the solvent, for example, the dimensions of an intermediate transfer body that is impregnated with the solvent for one hour at room temperature and then is subjected to drying under reduced pressure (10 Pa, 80°C, two hours) may be tentatively used.

Examples of the intermediate transfer body including the fibrous core material include an intermediate transfer body in which there is laminated a mold part where a pattern shape of a recess-protrusion shape is imparted onto the fibrous core material hardened with resin similar to the intermediate transfer body. Examples of the fibrous core material include fabric including a material having low elasticity. Specific examples thereof include nonwoven fabric made of cellulose, cotton or the like, and woven fabric such as glass cloth. By using an intermediate transfer body including a fibrous core material, the intermediate transfer body is strengthened by the fibrous core material, and stable transfer properties may be obtained without being affected by a tensile force at the time of transfer. Furthermore, since the fibrous core material suppresses the volume change due to heat and the swelling due to the solvent, the deformation of the intermediate transfer body itself may be suppressed.

Examples of the resin for forming the intermediate transfer body include polysiloxane (dimethylpolysiloxane or the like) as a silicone-based resin, a fluorine-based resin, polyolefin-based resin (polyethylene, polypropylene, polycyclic olefin, or the like), polyethersulfone-based resin, polycarbonate-based resin, polyester-based resin (polyarylate, polyethylene terephthalate, polyethylene naphthalate, or the like), polyamide-based resin, polymethyl methacrylate and the like. Among the above resins, polysiloxane is particularly preferred. Examples of the curable composition forming the intermediate transfer body include polysiloxane containing an epoxy compound and the like. When polysiloxane is used as the resin, the compatibility with a curable composition such as an epoxy compound is excellent, and the contact angle is likely to be small. In addition, when polysiloxane is used as the above-discussed resin and curable composition, the intermediate transfer body is excellent in flexibility, and thus a protruding portion of an opposing mold may extend flexibly along the intermediate transfer body and may be in contact with the intermediate transfer body when used in the offset scheme. As a result, the ink applied to the intermediate transfer body may be adsorbed on the protruding portion of the mold without nonuniformity. Furthermore, since the intermediate transfer body is excellent in releasability and flexibility, the intermediate transfer body may be more easily taken out.

Subsequently, as illustrated in FIG. 7(B), the mold 30 is pressed against the ink 42 having been applied on the intermediate transfer body 50. The mold 30 is pressed in such a manner that the side at which the protrusion 44 is present faces the intermediate transfer body 50. A pressure is applied as needed from a side opposite to the side where the mold 30 is pressed against the ink 42 by a roller 51. It is preferable for the pressure to be 1000 Pa or larger, more preferable to be 10000 Pa or larger, and further more preferable to be 100000 Pa or larger. With this, the mold 30 is evenly pressed against the intermediate transfer body 50 side by the roller 51 without nonuniformity. Accordingly, the ink 42 can evenly adhere to the protrusion 44 of the mold 30.

As illustrated in FIG. 7(C), the mold 30 is separated from the intermediate transfer body 50. At this time, the ink 42 is separated from the intermediate transfer body 50 while being adsorbed on the protrusion 44 of the mold 30. As a result, the ink 42 adsorbed on the protrusion 44 of the mold 30 is removed from the intermediate transfer body 50, and the ink 42 having a protrusion shape is left on the intermediate transfer body 50 at a position corresponding to a recess of the mold 30.

As illustrated in FIG. 7(D), the intermediate transfer body 50 is pressed against the substrate 12 having the electrode 15. It is preferable that the electrode 15 be disposed at a location facing the ink 42 left on the intermediate transfer body 50 when the substrate 12 faces the intermediate transfer body 50. The electrodes 15 may be disposed at the locations facing all of pieces of the ink 42, or at the locations facing some of the pieces of the ink 42 as needed.

A side at which the ink 42 of the intermediate transfer body 50 is present and a side at which the electrode 15 of the substrate 12 is provided face each other and are pressed against each other. Thus, the ink 42 present on the intermediate transfer body 50 is pressed against the electrode 15 of the substrate 12. A pressure is applied as needed from a side opposite to the side where the intermediate transfer body 50 is pressed against the ink 42 by a roller 52. It is preferable for the pressure to be 1000 Pa or larger, more preferable to be 10000 Pa or larger, and further more preferable to be 100000 Pa or larger. With this, the intermediate transfer body 50 is evenly pressed against the substrate 12 side by the roller 52 without nonuniformity. Accordingly, the ink 42 can evenly adhere onto the electrode 15 of the substrate 12.

As illustrated in FIG. 5(E), the intermediate transfer body 50 is separated from the substrate 12. At this time, the ink 42 is separated from the intermediate transfer body 50 while being adsorbed on the electrode 15 of the substrate 12. Thus, the microcontact printing method of the inverted offset technique using the intermediate transfer body 50 may precisely transfer the ink 42 onto a plurality of locations on the electrodes 15 at a time.

### Method for Mounting Semiconductor Element on Substrate

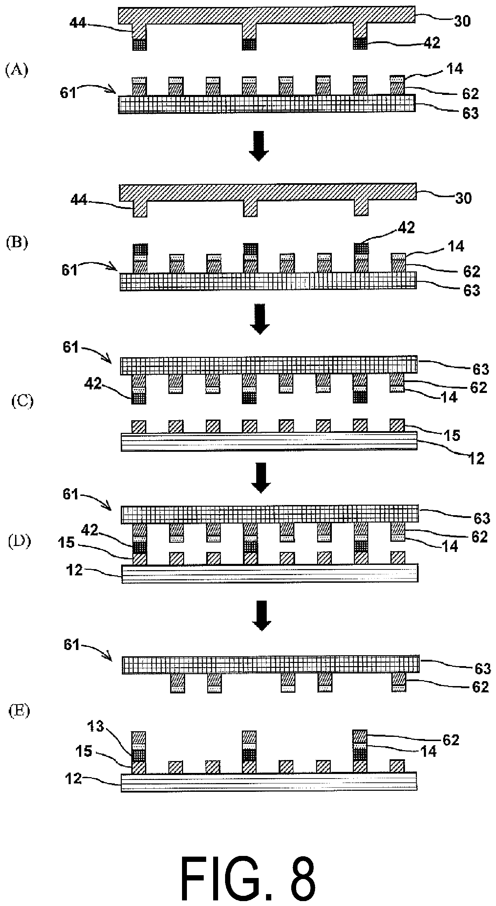

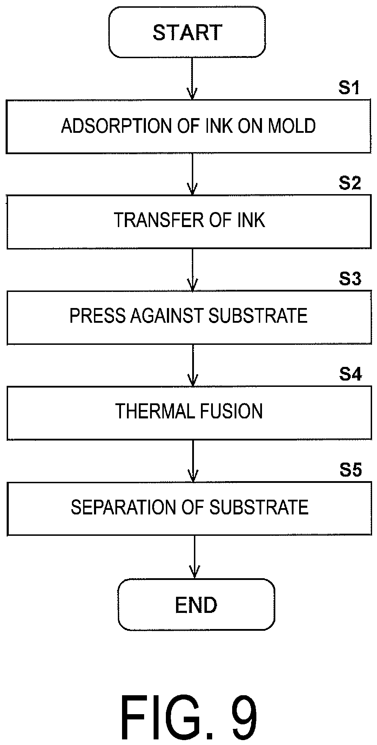

FIGS. 8(A) to 8(E) are schematic diagrams illustrating a method for mounting a semiconductor element onto a substrate according to the present disclosure (hereinafter, also referred to simply as a mounting method). FIG. 9 is a flowchart illustrating a mounting method of the present disclosure. The description thereof will be given below with reference to FIGS. 8(A) to 8(E) and FIG. 9. In the description of the method for mounting a semiconductor element onto a substrate, an LED display is explained as an example of a mounted structure. Here, the microcontact printing method is described with reference to a case of using transfer method 1 described above, but is not limited thereto. The same contents as those of transfer method 1 described above are omitted in the description of the mounting method.

The LED display is a device in which the plurality of semiconductor elements 11 are mounted on the substrate 12, as illustrated in FIG. 1(A), for example. In the LED display, the plurality of semiconductor elements 11 include three types of LED elements of R, G, and B. Therefore, it is necessary to mount each LED element at a position determined for each of the types of R, G and B on the substrate 12. The LED elements of three types of R, G, and B need to be mounted in an orderly manner with no deviation to prevent the generation of color unevenness or the like.

First, as illustrated in FIG. 8(A), the mold 30 and an LED chip board 61 are prepared. Ink 42 is evenly adsorbed on the tip of the protrusion 44 of the mold 30. The ink 42 containing metal nanoparticles is previously adsorbed on the mold 30 according to transfer method 1 described above (S 1 in FIG. 9). The LED chip board 61 is a member where a plurality of LED elements 62, which are semiconductor elements, are loaded on a chip board 63. For example, the plurality of LED elements 62 are the LED elements of R among R, G, and B. The LED element 62 includes the terminal 14. The terminal 14 is disposed on the LED element 62 at a side in the opposite direction with respect to a side connected to the chip board 63.

The protrusion 44 of the mold 30, when overlaid on the mold 30, overlaps some of the plurality of LED elements 62 of the LED chip board 61 in a plan view. In a case where three types of LED elements are required as in the LED display, the protrusions 44 are preferably formed to overlap only the LED elements 62 at the locations where the LED elements of R are required. With this, when the mold 30 is pressed against the LED chip board 61, the protrusions 44 may be in contact with the locations where the LED elements of R are required. Thereafter, the mold 30 is separated from the LED chip board 61.

As illustrated in FIG. 8(B), the ink 42 adsorbed on the tip of the protrusion 44 is transferred onto the terminal 14 of the LED element 62 in contact with the ink 42 (S2 in FIG. 9). In this manner, the mounting method may precisely transfer the ink 42 onto a plurality of locations at a time.

Subsequently, as illustrated in FIG. 8(C), the substrate 12 is prepared. As described above, the plurality of electrodes 15 are formed on the surface of the substrate 12. The electrodes 15 are preferably formed at the locations corresponding to at least the three types of LED elements of R, G, and B.

As illustrated in FIG. 8(D), the LED chip board 61 is pressed against the substrate 12 including the electrodes 15 (S3 in FIG. 9). With this, the plurality of LED elements 62 at the locations where the ink 42 has been transferred are in contact with the electrodes 15 at the corresponding locations. At this time, the terminal 14 on the LED element 62 is brought into contact with the electrode 15 on the substrate 12 via the ink 42. In other words, the terminal 14 and the electrode 15 are in contact with each other while pinching the ink 42 therebetween.

Heating is performed while the terminal 14 and the electrode 15 are in contact with each other via the ink 42 (S4 in FIG. 9). The metal nanoparticles in the ink 42 are thermally fused by heating, thereby forming the joining portion 13. As described above, the joining portion 13 may be mixed with part of the terminal 14 and electrode 15 fused by the thermal fusion, and may be integrated with the terminal 14 and electrode 15. Thus, the terminal 14 and the electrode 15 are joined.

Subsequently, as illustrated in FIG. 8(E), the LED chip board 61 is separated from the substrate 12 (S5 in FIG. 9). With this, the plurality of LED elements 62, which are the LED elements of R, are precisely mounted on the substrate 12 at a time. By using a similar method, the LED elements of G or B may be mounted on the substrate 12. Thus, in the LED display, the LED elements of the three types of R, G, and B may be mounted on the substrate 12 at a time for each type. Accordingly, the time and manpower may be significantly reduced compared to a case in which the LED elements 62 are mounted one by one on the substrate 12.

### Examples

Hereinafter, the present disclosure will be described more specifically with reference to examples, but the present disclosure is not limited to these examples, and modifications and improvements within the scope of achieving the object of the present disclosure are encompassed by the present disclosure. Molds used in Example 1, Transfer Examples 1 to 3, and Reference Example 1 were prepared by the methods described in Production Examples 1 to 3 given below.

### Production Example 1

### Production Example of Mold (A)

In Production Example 1, a case in which the mold is a film formed of a cured product of a resin composition is exemplified.

Liquid polysiloxane composition 1 was prepared by mixing a liquid polysiloxane (PDMS) ("SIM-260" available from Shin-Etsu Chemical Co., ltd.) and a curing agent ("CAT 260" available from Shin-Etsu Chemical Co., ltd.) in a ratio (weight ratio) of liquid polysiloxane/curing agent = 10/1. A master mold (made of silicon, a square with a side of 20 mm in a plan view, a transfer portion being a square with a side of 5 mm in the plan view, 100 x 100 holes, the hole size being 10 µm, the hole depth being 10 µm, the shortest distance between holes being 10 µm, the shortest distance from an edge for holes in the transfer portion being 20 µm) imparted with a pattern of recesses and protrusions and having a thickness of 1 mm in the lamination direction was fixed on a glass substrate.

Subsequently, a frame (made of Teflon (trademark), the inner size being a square with a side of 20 mm in a plan view, the thickness in the lamination direction being 3 mm) was fixed on the glass substrate to surround the master mold. The prepared liquid polysiloxane composition 1 was fed into a space surrounded by the master mold and the frame. The fed liquid polysiloxane composition 1 was degassed under reduced pressure (pressure 10 Pa) for 30 minutes, and then a glass substrate was pasted on the upper portion of the liquid polysiloxane composition 1 while preventing bubbles from entering into a gap between the glass substrate and the liquid polysiloxane composition 1. After having cured the liquid polysiloxane composition 1 at 150°C for two hours, the aforementioned glass substrate, frame, and master mold were separated to obtain a mold (A). A film-shaped mold (A) with a film thickness of 2 mm was obtained, where a pillar-shaped pattern (size of a protrusion pattern: 10 µm, height of a protrusion: 10 µm) was formed on the surface of the mold.

### Production Example 2

### Production Example of Mold (B)

In Production Example 2, a case where the mold is a fibrous core material-containing mold will be described. A cellulose nonwoven fabric (40 mm square) was prepared as the fibrous core material. The same description as that in Production Example 1 is omitted in the description of Production Example 2.

Liquid polysiloxane composition 2 was prepared by mixing a liquid polysiloxane (PDMS) ("SIM-260" available from Shin-Etsu Chemical Co., ltd.), a curing agent ("CAT 260" available from Shin-Etsu Chemical Co., ltd.), and acetone in a ratio (weight ratio) of liquid polysiloxane/curing agent/acetone = 10/1/3. A gadget in which a cellulose nonwoven fabric is set stretching over an aluminum-made frame having an opening of 30 mm square was put into the liquid polysiloxane composition 2 stored in a tray, and was left therein for 30 minutes to cause the cellulose nonwoven fabric to be impregnated with the liquid polysiloxane composition 2. After the aluminum-made frame was pulled up and an excess of the liquid polysiloxane composition 2 was wiped off with a squeegee, the aluminum-made frame was left still for 24 hours at 23°C in a state of being vertically suspended. Thereafter, the liquid polysiloxane composition 2 was cured by heating at 150°C for two hours to fabricate a sheet-shaped mold base material (thickness in the lamination direction: 0.5 mm).

Similar to Production Example 1, a master mold was fixed on a glass substrate, and a frame (made of Teflon (trademark), the inner size being a square with a side of 20 mm in a plan view, the thickness in the lamination direction being 2.0 mm) was fixed on the glass substrate to surround the master mold. The prepared liquid polysiloxane composition 1 was fed into a space surrounded by the master mold and the frame. After degassing under reduced pressure, the fabricated sheet-shaped mold base material was pasted on the upper portion of the liquid polysiloxane composition 1 while preventing bubbles from entering into a gap between the sheet-shaped mold base material and the liquid polysiloxane composition 1. After having cured the liquid polysiloxane composition 1, the glass substrate, the frame, and the master mold were separated to obtain a mold (B) (the thickness in the lamination direction (a location where the sheet-shaped mold base material and the cured product of the liquid polysiloxane composition 1 were laminated): 1.5 mm).

### Production Example 3

### Production Example of Mold (C)

In Production Example 3, a mold used in Reference Example 1 is described. The same description as that in Production Example 1 is omitted in the description of Production Example 3.

An amount of 10 g of cycloolefin copolymer TOPAS (available from Polyplastics Co., Ltd.) was dissolved in 100 ml of a toluene solvent. The prepared toluene solution was spin-coated on a quartz substrate, and then was subjected to heating for 10 minutes on a 100°C hot plate to remove the solvent. Thus, a coating film with a thickness of 2 to 10 µm was formed in a dry state. Subsequently, the above-discussed master mold was subjected to pressure transfer at 160°C using an imprint device (NM-0401, available from MEISYO KIKO Co., Ltd.). A mold (C) was obtained by mold releasing from the master mold at room temperature.

Transfer Examples 1 to 3 and Reference Example 1 are described below. The mold (A) obtained in Production Example 1 was used in Transfer Examples 1 and 3, the mold (B) obtained in Production Example 2 was used in Transfer Example 2, and the mold (C) obtained in Production Example 3 was used in Reference Example 1.

### Transfer Example 1

DSN-0351P (available from DAICEL CORPORATION) was diluted with a glycol solvent (dipropylene glycol monobutyl ether) in a ratio of DSN-0351P/glycol solvent 1/1 to obtain a silver nanoparticle dispersion liquid. The obtained silver nanoparticle dispersion liquid was spin-coated on a glass substrate at 3000 rpm for 30 seconds to fabricate a liquid coating film with a thickness of 3 µm. Subsequently, the mold (A) of Production Example 1 was set on the fabricated liquid coating film, and the silver nanoparticle dispersion liquid attached to the protrusion of the mold (A) was transferred onto the glass substrate. The transferred product transferred on the glass substrate was observed by using an optical microscope (DM4000M, available from Leica Microsystems). It was confirmed that the silver nanoparticle dispersion liquid was faithfully transferred onto the glass substrate according to the shape of the protrusion of the mold (A) from the observation result by the optical microscope.

### Transfer Example 2

The transfer of silver nano-ink was carried out in the same manner as in Transfer Example 1 except that the mold (B) of Production Example 2 was used. It was confirmed that the silver nanoparticle dispersion liquid was faithfully transferred onto the glass substrate according to the shape of the protrusion of the mold (B) from the observation result by the optical microscope. In addition, it was confirmed that mold (B) was reinforced with the cellulose nonwoven fabric and exhibited stable transfer properties without being affected by a tensile force during the transfer.

### Transfer Example 3

DSN-0351P (available from DAICEL CORPORATION) was applied using an applicator on the sheet-shaped mold base material of Production Example 2 to obtain a film thickness of 5 µm. Subsequently, the mold (A) of Production Example 1 was pressed against a liquid coating film of the silver nanoparticle dispersion liquid formed by the applicator application, and the silver nanoparticle dispersion liquid at the location corresponding to the protrusion of the mold (A) was removed. As a result, the silver nanoparticle dispersion liquid remained at the location corresponding to the recess of the mold (A) on the sheet-shaped mold base material. Subsequently, the remaining silver nanoparticle dispersion liquid on the sheet-shaped mold base material was transferred onto the glass substrate. It was confirmed that the silver nanoparticle dispersion liquid was faithfully transferred onto the glass substrate according to the shape of the recess of the mold (A) from the observation result by the optical microscope.

### Reference Example 1

The transfer of silver nano-ink was carried out in the same manner as in Transfer Example 1 except that the mold (C) of Production Example 3 was used. It was confirmed that the silver nanoparticle dispersion liquid was transferred onto the glass substrate according to the shape of the protrusion of the mold (C) from the observation result by the optical microscope, but areas in which ink transfer was incorrectly carried out were partially found.

### Example 1

### Example of Joining

A liquid coating film made of a silver nanoparticle dispersion liquid and having a thickness of 3 µm was fabricated on a glass substrate in the same manner as in Transfer Example 1. The mold (A) of Production Example 1 was set on the liquid coating film made of the silver nanoparticle dispersion liquid, and the silver nanoparticle dispersion liquid attached to the protrusion of the mold (A) was transferred onto a polyimide film. Subsequently, the polyimide film was set on a glass substrate including a copper bump having the same pattern shape as that of the master mold. At this time, the copper bump on the glass substrate was laminated in an orientation facing the silver nanoparticle dispersion liquid transferred onto the polyimide film. The laminated glass substrate and the polyimide film were heated at 200°C for 30 minutes. The silver nanoparticles were thermally fused with the copper bump on the glass substrate. This resulted in the polyimide film being joined with the copper bump on the glass substrate. The joining state was observed from the glass surface by using an optical microscope (DM4000M, available from Leica Microsystems). From the observation result by the optical microscope, it was confirmed that the polyimide film was joined with the copper bump on the glass substrate.

Hereinafter, variations of the invention according to the present disclosure will be described.

[Appendix 1] A mounted structure in which a semiconductor element including a terminal is mounted on a substrate including an electrode, the mounted structure including a joining portion that joins the terminal and the electrode to make the terminal and the electrode oppose each other, wherein
the electrode is a bump of a bulk metal material disposed on the substrate, and
the joining portion is obtained by thermally fusing metal nanoparticles in ink containing the metal nanoparticles transferred onto at least one of the electrode or the terminal by using a microcontact printing method.

[Appendix 2] The mounted structure according to Appendix 1, wherein the average particle size of the metal nanoparticles is in a range from 0.5 nm to 100 nm (preferably from 0.5 nm to 35 nm, more preferably from 0.5 nm to 25 nm).

[Appendix 3] The mounted structure according to Appendix 1 or 2, wherein a mold used in the microcontact printing method contains polysiloxane as a constituent material.

[Appendix 4] The mounted structure according to any one of Appendices 1 to 3, wherein the mold used in the microcontact printing method uses a mold made of a film or a mold made of polysiloxane containing a fibrous core material, a linear expansion coefficient of the mold being 200 ppm/K or less (preferably 100 ppm/K or less, more preferably 50 ppm/K) or less and a size of the mold being unchanged before and after being used repeatedly using a solvent.

[Appendix 5] The mounted structure according to any one of Appendices 1 to 4, wherein
the microcontact printing method is a letterpress printing scheme using a mold, and
the ink containing the metal nanoparticles transferred onto at least one of the electrode or the terminal is ink obtained by transferring a portion of the ink that is adsorbed on a protrusion of the mold when the mold is pressed against the ink having been evenly applied on a flat plate.

[Appendix 6] The mounted structure according to any one of Appendices 1 to 4, wherein
the microcontact printing method is an intaglio printing scheme using a mold, and
the ink containing the metal nanoparticles transferred onto at least one of the electrode or the terminal is ink obtained by transferring the ink that is filled in a recess of the mold when the mold is pressed against the ink having been evenly applied on a flat plate.

[Appendix 7] The mounted structure according to any one of Appendices 1 to 4, wherein
the microcontact printing method is an offset-technique printing scheme using a mold and an intermediate transfer body, and
the ink containing the metal nanoparticles transferred onto at least one of the electrode or the terminal is ink obtained by transferring, onto at least one of the electrode on the substrate or the terminal, the ink that remains on the intermediate transfer body when the mold is pressed against the ink having been evenly applied on the intermediate transfer body and is separated from the intermediate transfer body.

[Appendix 8] The mounted structure according to Appendix 7, wherein the intermediate transfer body contains polysiloxane as a constituent material.

[Appendix 9] The mounted structure according to Appendix 7 or 8, wherein the intermediate transfer body is an intermediate transfer body made of a film or an intermediate transfer body made of polysiloxane containing a fibrous core material, a linear expansion coefficient of the intermediate transfer body being 200 ppm/K or less and a size thereof being unchanged before and after being used repeatedly using a solvent.

[Appendix 10] The mounted structure according to any one of Appendices 1 to 9, wherein the semiconductor element is an LED element in which a length of the longest line among the lines connecting any two points on an outer periphery of the semiconductor element in a plan view is 100 µm or less.

[Appendix 11] The mounted structure according to any one of Appendices 1 to 10, wherein the semiconductor element has a rectangular shape in a plan view.

[Appendix 12] The mounted structure according to Appendix 11, wherein a diagonal line length of the rectangular shape is 70 µm or less (preferably 35 µm or less).

[Appendix 13] The mounted structure according to any one of Appendices 1 to 10, wherein the semiconductor element has a circular shape in a plan view.

[Appendix 14] The mounted structure according to Appendix 13, wherein a diameter of the circular shape is 50 µm or less (more preferably 20 µm or less).

[Appendix 15] The mounted structure according to any one of Appendices 1 to 14, wherein the metal nanoparticles are silver nanoparticles.

[Appendix 16] An optical member including the mounted structure according to any one of Appendices 1 to 15.

[Appendix 17] An LED display including the mounted structure according to any one of Appendices 1 to 15.

[Appendix 18] A mounting method for mounting a semiconductor element including a terminal onto a substrate including an electrode that is a bump of a bulk metal material disposed on the substrate, the mounting method including:
transferring ink containing metal nanoparticles onto at least one of the electrode or the terminal by using a microcontact printing method; and
performing thermal fusion in a state in which the terminal and the electrode are in contact with each other, interposed with the ink containing the metal nanoparticles transferred onto at least one of the electrode or the terminal.

[Appendix 19] The mounting method according to Appendix 18, wherein an average particle size of the metal nanoparticles is in a range from 0.5 nm to 100 nm.

[Appendix 20] The mounting method according to Appendix 18 or 19, wherein a mold used in the microcontact printing method contains polysiloxane as a constituent material.

[Appendix 21] The mounting method according to any one of Appendices 18 to 20, wherein the mold used in the microcontact printing method uses a mold made of a film or a mold made of polysiloxane containing a fibrous core material, a linear expansion coefficient of the mold being 200 ppm/K or less (preferably 100 ppm/K or less, more preferably 50 ppm/K) or less and a size of the mold being unchanged before and after being used repeatedly using a solvent.

[Appendix 22] The mounting method according to any one of Appendices 18 to 21,
wherein the microcontact printing method is a letterpress printing scheme, and
the mounting method includes,
pressing the mold against the ink containing the metal nanoparticles having been evenly applied on a flat plate,
separating the mold from the flat plate, and
transferring the ink adsorbed on a protrusion of the mold onto at least one of the electrode or the terminal.

[Appendix 23] The mounting method according to any one of Appendices 18 to 21,
wherein the microcontact printing method is an intaglio printing scheme, and
the mounting method includes,
pressing the mold against the ink containing the metal nanoparticles having been evenly applied on a flat plate,
separating the mold from the flat plate, and
transferring the ink that is filled in a recess of the mold onto at least one of the electrode or the terminal.

[Appendix 24] The mounting method according to any one of Appendices 18 to 21,
wherein the microcontact printing method is an offset-technique printing scheme using a mold and an intermediate transfer body, and
the mounting method includes,
pressing the mold against the ink containing the metal nanoparticles having been evenly applied on the intermediate transfer body,
removing a portion of the ink corresponding to a protrusion of the mold from an upper portion of the intermediate transfer body by separating the mold from the intermediate transfer body, and
transferring the ink remaining on the intermediate transfer body onto at least one of the electrode or the terminal.

[Appendix 25] The mounting method according to Appendix 24, wherein the intermediate transfer body contains polysiloxane as a constituent material.

[Appendix 26] The mounting method according to Appendix 24 or 25, wherein the intermediate transfer body is an intermediate transfer body made of a film or an intermediate transfer body made of polysiloxane containing a fibrous core material, a linear expansion coefficient of the intermediate transfer body being 200 ppm/K or less and a size thereof being unchanged before and after being used repeatedly using a solvent.

[Appendix 27] The mounting method according to any one of Appendices 18 to 26, wherein the semiconductor element is an LED element in which a length of the longest line among the lines connecting any two points on an outer periphery of the semiconductor element in a plan view is 100 µm or less.

[Appendix 28] The mounting method according to any one of Appendices 18 to 27, wherein the semiconductor element has a rectangular shape in a plan view.

[Appendix 29] The mounting method according to Appendix 28, wherein a diagonal line length of the rectangular shape is 70 µm or less (preferably 35 µm or less).

[Appendix 30] The mounting method according to any one of Appendices 18 to 27, wherein the semiconductor element has a circular shape in a plan view.

[Appendix 31] The mounting method according to Appendix 30, wherein a diameter of the circular shape is 50 µm or less (more preferably 20 µm or less).

[Appendix 32] The mounting method according to any one of Appendices 18 to 31, wherein the metal nanoparticles are silver nanoparticles.

### Industrial Applicability

The mounting method of the present disclosure may mount a plurality of semiconductor elements on a substrate at a time efficiently and precisely with little joining deviation. The mounted structure of the present disclosure is a structure in which the semiconductor elements are precisely mounted on the substrate at a time with little joining deviation. Thus, the mounting method and the mounted structure of the present disclosure may be preferably used, for example, as an optical component such as an LED (including an LED display), a display element for head-up display, a backlight of a liquid crystal display or the like, lighting, or a visible light communication device. The semiconductor elements 11 can be efficiently and precisely mounted on the substrate, and therefore the mounted structure of the present disclosure may be preferably used as a specially miniaturized device, for example, as a micro LED or the like.

### Reference Signs List

10, 101 Mounted structure
11, 111, 112, 113 Semiconductor element
12 Substrate
13 Joining portion
14 Terminal
15 Electrode
20 Master mold
21 Transfer portion
22 Peripheral portion
23 Recess
24 Edge of transfer portion
30 Mold
31 Plate
32 Frame
34 Mold-forming resin composition
35 Base member
41 Flat plate
42 Ink
43, 45 Roller
44 Protrusion
46 Recess
47 Spatula
50 Intermediate transfer body
51, 52 Roller
61 LED chip board
62 LED element
63 Chip board

## Claims

1. A mounted structure in which a semiconductor element including a terminal is mounted on a substrate including an electrode, the mounted structure comprising a joining portion that joins the terminal and the electrode to make the terminal and the electrode oppose each other,
wherein the electrode is a bump of a bulk metal material disposed on the substrate, and
the joining portion is obtained by thermally fusing metal nanoparticles in ink containing the metal nanoparticles transferred onto at least one of the electrode or the terminal by using a microcontact printing method.

2. The mounted structure according to claim 1,
wherein an average particle size of the metal nanoparticles is in a range from 0.5 nm to 100 nm.

3. The mounted structure according to claim 1 or 2,
wherein a mold used in the microcontact printing method contains polysiloxane as a constituent material.

4. The mounted structure according to any one of claims 1 to 3,
wherein the mold used in the microcontact printing method uses a mold made of a film or a mold made of polysiloxane containing a fibrous core material, a linear expansion coefficient of the mold being 200 ppm/K or less and a size of the mold being unchanged before and after being used repeatedly using a solvent.

5. The mounted structure according to any one of claims 1 to 4,
wherein the microcontact printing method is a letterpress printing scheme using a mold, and
the ink containing the metal nanoparticles transferred onto at least one of the electrode or the terminal is ink obtained by transferring a portion of the ink that is adsorbed on a protrusion of the mold when the mold is pressed against the ink having been evenly applied on a flat plate.

6. The mounted structure according to any one of claims 1 to 4,
wherein the microcontact printing method is an intaglio printing scheme using a mold, and
the ink containing the metal nanoparticles transferred onto at least one of the electrode or the terminal is ink obtained by transferring the ink that is filled in a recess of the mold when the mold is pressed against the ink having been evenly applied on a flat plate.

7. The mounted structure according to any one of claims 1 to 4,
wherein the microcontact printing method is an offset-technique printing scheme using a mold and an intermediate transfer body, and
the ink containing the metal nanoparticles transferred onto at least one of the electrode or the terminal is ink obtained by transferring, onto at least one of the electrode on the substrate or the terminal, the ink that remains on the intermediate transfer body when the mold is pressed against the ink having been evenly applied on the intermediate transfer body and is separated from the intermediate transfer body.

8. The mounted structure according to any one of claims 1 to 7,
wherein the semiconductor element is an LED element in which a length of the longest line among lines connecting any two points on an outer periphery of the semiconductor element in a plan view is 100 µm or less.

9. An LED display comprising the mounted structure according to any one of claims 1 to 8.

10. A mounting method for mounting a semiconductor element including a terminal onto a substrate including an electrode that is a bump of a bulk metal material disposed on the substrate, the mounting method comprising:
transferring ink containing metal nanoparticles onto at least one of the electrode or the terminal by using a microcontact printing method; and
performing thermal fusion in a state in which the terminal and the electrode are in contact with each other, interposed with the ink containing the metal nanoparticles transferred onto at least one of the electrode or the terminal.

11. The mounting method according to claim 10,
wherein an average particle size of the metal nanoparticles is in a range from 0.5 nm to 100 nm.

12. The mounting method according to claim 10 or 11,
wherein a mold used in the microcontact printing method contains polysiloxane as a constituent material.

13. The mounting method according to any one of claims 10 to 12,
wherein the mold used in the microcontact printing method uses a mold made of a film or a mold made of polysiloxane containing a fibrous core material, a linear expansion coefficient of the mold being 200 ppm/K or less and a size of the mold being unchanged before and after being used repeatedly using a solvent.

14. The mounting method according to any one of claims 10 to 13,
wherein the microcontact printing method is a letterpress printing scheme, and
the mounting method includes,
pressing the mold against the ink containing the metal nanoparticles having been evenly applied on a flat plate,
separating the mold from the flat plate, and
transferring the ink adsorbed on a protrusion of the mold onto at least one of the electrode or the terminal.

15. The mounting method according to any one of claims 10 to 13,
wherein the microcontact printing method is an intaglio printing scheme, and
the mounting method includes,
pressing the mold against the ink containing the metal nanoparticles having been evenly applied on a flat plate,
separating the mold from the flat plate, and
transferring the ink that is filled in a recess of the mold onto at least one of the electrode or the terminal.

16. The mounting method according to any one of claims 10 to 13,
wherein the microcontact printing method is an offset-technique printing scheme using a mold and an intermediate transfer body, and
the mounting method includes,
pressing the mold against the ink containing the metal nanoparticles having been evenly applied on the intermediate transfer body,
removing a portion of the ink corresponding to a protrusion of the mold from an upper portion of the intermediate transfer body by separating the mold from the intermediate transfer body, and
transferring the ink remaining on the intermediate transfer body onto at least one of the electrode or the terminal.
